# EUROPEAN PATENT APPLICATION

(11) **EP 2 848 657 A1**
(43) Date of publication of application: **18.03.2015**
(21) Application number: 13004506.5
(22) Date of filing: 16.09.2013
(51) Int. Cl.: C09D 11/00, C08L 1/28, H01B 1/22, H01L 31/0224, C08K 3/08, C08K 3/22

(54) **Electroconductive paste with adhesion promoting glass**

(71) Applicant: Heraeus Precious Metals North America Conshohocken LLC, West Conshohocken, PA 19428 (US)
(72) Inventor: Kurtz, Eric, Philadelphia, PA 19103 (US); Karpowich, Lindsey A., Philadelphia, PA 19106 (US); Zhang, Weiming, Blue Bell, PA 19422 (US)
(74) Representative: Herzog, Martin

(57) **Abstract**

An electroconductive paste composition for use in forming backside soldering pads on a solar cell including metallic particles, glass frit including Bi₂O₃, Al₂O₃, SiO₂, B₂O₃ and at least one of Li₂O or Li₃PO₄, and an organic vehicle is provided. The invention also provides a solar cell comprising a silicon wafer having a front side and a backside, and a soldering pad formed on the silicon wafer produced from an electroconductive paste according to the invention. The invention further provides a solar cell module comprising electrically interconnected solar cells according to the invention. A method of producing of a solar cell, comprising the steps of providing a silicon wafer having a front side and a backside, applying an electroconductive paste composition according to the invention onto the backside of the silicon wafer, and firing the silicon wafer according to an appropriate profile, is also provided.

## Description

### FIELD OF THE INVENTION

This invention relates to electroconductive paste compositions utilized in solar panel technology, especially for forming backside soldering pads. Specifically, in one aspect, the invention is an electroconductive paste composition comprising conductive particles, an organic vehicle and glass frit. The glass frit includes Bi₂O₃, Al₂O₃, SiO₂, B₂O₃, and at least one of Li₂O or Li₃PO₄. According to another embodiment, the electroconductive paste composition may further comprise an adhesion enhancer. Another aspect of the invention is a solar cell produced by applying the electroconductive paste of the invention to the backside of a silicon wafer to form soldering pads. The invention also provides a solar panel comprising electrically interconnected solar cells. According to another aspect, the invention also provides a method of producing a solar cell.

### BACKGROUND OF THE INVENTION

Solar cells are devices that convert the energy of light into electricity using the photovoltaic effect. Solar power is an attractive green energy source because it is sustainable and produces only non-polluting by-products. Accordingly, a great deal of research is currently being devoted to developing solar cells with enhanced efficiency while continuously lowering material and manufacturing costs.

When light hits a solar cell, a fraction of the incident light is reflected by the surface and the remainder is transmitted into the solar cell. The photons of the transmitted light are absorbed by the solar cell, which is usually made of a semiconducting material such as silicon. The energy from the absorbed photons excites electrons of the semiconducting material from their atoms, generating electron-hole pairs. These electron-hole pairs are then separated by p-n junctions and collected by conductive electrodes applied on the solar cell surface.

The most common solar cells are those made of silicon. Specifically, a p-n junction is made from silicon by applying an n-type diffusion layer onto a p-type silicon substrate, coupled with two electrical contact layers or electrodes. In a p-type semiconductor, dopant atoms are added to the semiconductor in order to increase the number of free charge carriers (positive holes). Essentially, the doping material takes away weakly bound outer electrons from the semiconductor atoms. One example of a p-type semiconductor is silicon with a boron or aluminum dopant. Solar cells can also be made from n-type semiconductors. In an n-type semiconductor, the dopant atoms provide extra electrons to the host substrate, creating an excess of negative electron charge carriers. One example of an n-type semiconductor is silicon with a phosphorous dopant. In order to minimize reflection of the sunlight by the solar cell, an antireflective coating, such as silicon nitride, is applied to the n-type diffusion layer to increase the amount of light coupled into the solar cell.

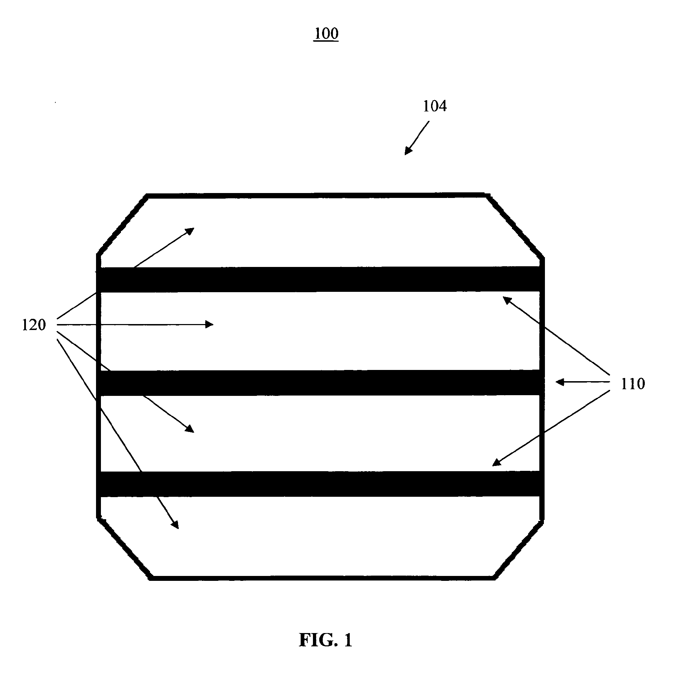

Solar cells typically have electroconductive pastes applied to both their front and back surfaces. The front side pastes result in the formation of electrodes that conduct the electricity generated from the exchange of electrons, as described above, while the backside pastes serve as solder joints for connecting solar cells in series via a solder coated conductive wire. To form a solar cell, a rear contact is first applied to the backside of the silicon wafer to form soldering pads, such as by screen printing a silver paste or silver/aluminum paste. Next, an aluminum backside paste is applied to the entire backside of the silicon wafer, slightly overlapping the soldering pads' edges, and the cell is then dried. Figure 1 shows a silicon solar cell 100 having soldering pads 110 running across the length of the cell, with an aluminum backside 120 printed over the entire surface. Lastly, using a different type of electroconductive paste, typically a silver-comprising paste, a metal contact may be screen printed onto the front side of the silicon wafer to serve as a front electrode. This electrical contact layer on the face or front of the cell, where light enters, is typically present in a grid pattern made of finger lines and bus bars, rather than a complete layer, because the metal grid materials are typically not transparent to light. The silicon substrate, with the printed front side and backside paste, is then fired at a temperature of approximately 700-975°C. During firing, the front side paste etches through the antireflection layer, forms electrical contact between the metal grid and the semiconductor, and converts the metal pastes to metal electrodes. On the backside, the aluminum diffuses into the silicon substrate, acting as a dopant which creates a back surface field (BSF). This field helps to improve the efficiency of the solar cell.

The resulting metallic electrodes allow electricity to flow to and from solar cells connected in a solar panel. To assemble a panel, multiple solar cells are connected in series and/or in parallel and the ends of the electrodes of the first cell and the last cell are preferably connected to output wiring. The solar cells are typically encapsulated in a transparent thermal plastic resin, such as silicon rubber or ethylene vinyl acetate. A transparent sheet of glass is placed on the front surface of the encapsulating transparent thermal plastic resin. A back protecting material, for example, a sheet of polyethylene terephthalate coated with a film of polyvinyl fluoride having good mechanical properties and good weather resistance, is placed under the encapsulating thermal plastic resin. These layered materials may be heated in an appropriate vacuum furnace to remove air, and then integrated into one body by heating and pressing. Furthermore, since solar modules are typically left in the open air for a long time, it is desirable to cover the circumference of the solar cell with a frame material consisting of aluminum or the like.

A typical electroconductive paste for backside use contains metallic particles, glass frit, and an organic vehicle. These components must be carefully selected to take full advantage of the theoretical potential of the resulting solar cell. The soldering pads formed by the backside paste, usually comprising silver or silver/aluminum, are particularly important, as soldering to an aluminum backside layer is practically impossible. The soldering pads may be formed as bars extending the length of the silicon substrate (as shown in Figure 1), or discrete segments arranged along the length of the silicone substrate. The soldering pads must adhere well to the silicon substrate, and must be able to withstand the mechanical manipulation of soldering a bonding wire, while having no detrimental effect on the efficiency of the solar cell.

A typical method used to test the adhesion of backside soldering pads is to apply a solder wire to the silver layer soldering pad and then measure the force required to peel off the soldering wire at a certain angle relative to the substrate, typically 180 degrees. Generally, a pull force of greater than 2 Newtons is the minimum requirement, with higher forces considered more desirable. Thus, compositions for backside pastes with improved adhesive strength are desired.

U.S. Patent Nos. 7,736,546 and 7,935,279 disclose lead-free glass frits which comprise TeO₂ and one or more of Bi₂O₃, SiO₂ and combinations thereof. The patents also disclose conductive inks comprising the glass frits and articles having such conductive inks applied. The electroconductive paste compositions of the '546 and '279 patents are used to form front side surface electrodes on a solar cell by penetrating the silicon substrate and forming ohmic contact therewith.

### SUMMARY OF THE INVENTION

The invention provides an electroconductive paste composition for use in forming backside soldering pads on a solar cell including metallic particles, glass frit including Bi₂O₃, Al₂O₃, SiO₂, B₂O₃ and at least one of Li₂O or Li₃PO₄, and an organic vehicle.

The invention further provides a solar cell including a silicon wafer having a front side and a backside, and a soldering pad formed on the silicon wafer produced from the electroconductive paste of the invention.

Another aspect of the invention relates to a solar cell module including electrically interconnected solar cells of the invention.

The invention also provides a method of producing a solar cell, including the steps of providing a silicon wafer having a front side and a backside, applying an electroconductive paste composition according to the invention onto the backside of the silicon wafer, and firing the silicon wafer according to an appropriate profile.

### BRIEF DESCRIPTION OF THE DRAWINGS

A more complete appreciation of the invention and many of the attendant advantages thereof will be readily obtained as the same becomes better understood by reference to the following detailed description when considered in connection with the following accompanying drawing, FIG. 1, which is a plan view of the backside of a silicon solar cell having printed silver soldering pads running across the length of the cell according to an exemplary embodiment of the invention.

### DETAILED DESCRIPTION

The invention relates to an electroconductive paste composition useful for application to the backside of a solar cell. The electroconductive paste composition preferably comprises metallic particles, glass frit, and an organic vehicle. The electroconductive paste may also comprise an adhesion enhancer. While not limited to such an application, such pastes may be used to form an electrical contact layer or electrode in a solar cell, as well as to form soldering pads used to interconnect solar cells in a module.

Figure 1 illustrates exemplary soldering pads 110 deposited on the backside of a silicon solar cell 100. In this particular example, screen printed silver soldering pads 110 run across the length of the silicon solar cell 100. In other configurations, the soldering pads may be of discrete segments. The soldering pads can be of any shape and size such as those known in the art. A second backside paste, e.g., a paste comprising aluminum, is also printed on the backside of the silicon solar cell 100 and makes contact with the edges of the soldering pads 110. This second backside paste forms the BSF 120 of the solar cell 100 when fired.

### Electroconductive Paste

One aspect of the invention relates to the composition of an electroconductive paste used to form backside soldering pads. A desired backside paste is one which has high adhesive strength to allow for optimal solar cell mechanical reliability, while also optimizing the solar cell's electrical performance. The electroconductive paste composition according to the invention is generally comprised of metallic particles, organic vehicle, and glass frit. The electroconductive paste composition may further comprise an adhesion enhancer. According to one embodiment, the backside electroconductive paste comprises about 30-75 wt% metallic particles, approximately 1-10 wt% glass frit, approximately 20-60 wt% organic vehicle, and approximately 0.01-5 wt% of an adhesion enhancer, based upon 100% total weight of the paste.

### Glass Frit

The glass frit of the invention improves the adhesive strength of the resulting electroconductive paste as compared to conventional paste compositions. The metallic content of an electroconductive paste used to print backside soldering pads has an effect on the adhesive strength of the paste. Higher metallic particle content, for example between 60-75 wt%, based upon 100% total weight of the paste, provides better adhesion because there is more solderable material available. When the metallic content is lower than 60 wt%, the adhesive forces are drastically reduced. Thus, the glass frit becomes even more important because it compensates for the reduction in adhesive strength. In addition, certain pastes used to form soldering pads can interact with the aluminum paste which is applied over the entire backside surface of the silicon solar cell to form the BSF. When this happens, blisters or defects form at the region where the backside soldering paste and the surface aluminum paste overlap. The glass compositions of the invention mitigate this interaction and provide lower overall rear grid and series resistance.

The glass frit of the invention preferably includes Bi₂O₃, Al₂O₃, SiO₂, B₂O₃, and at least one of Li₂O or Li₃PO₄. According to one embodiment, the glass frit comprises about 30-99.9%, preferably about 50-99.9%, more preferably about 70-90% of Bi₂O₃; about 0.01-15%, more preferably about 1-10%, of Al₂O₃; about 0.01-15%, more preferably about 1-10%, of SiO₂; about 0.01-10%, more preferably about 0.01-5%, of B₂O₃; and about 0.01-20%, more preferably about 5-15%, of Li₂O and/or Li₃PO₄, based upon 100% total weight of the glass component. Such a combination has been determined to improve the resulting adhesive properties of the paste composition over conventional pastes.

According to other embodiments of the invention, the glass frit present in the electroconductive paste may comprise other elements, oxides, compounds which generate oxides on heating, or mixtures thereof. Preferred elements in this context are Silicon, B, Al, Bi, Li, Na, Mg, Pb, Zn, Gd, Ce, Zr, Ti, Mn, Sn, Ru, Co, Fe, Cu, Ba and Cr, or combinations thereof. According to one embodiment, the glass frit may comprise lead or may be substantially lead-free. Preferred oxides which can be incorporated into the glass frit may include alkali metal oxides, alkali earth metal oxides, rare earth oxides, group V and group VI oxides, other oxides, or combinations thereof. Preferred alkali metal oxides in this context are sodium oxide, lithium oxide, potassium oxide, rubidium oxides, cesium oxides or combinations thereof. Preferred alkali earth metal oxides in this context are beryllium oxide, magnesium oxide, calcium oxide, strontium oxide, barium oxide, or combinations thereof. Preferred group V oxides in this context are phosphorous oxides, such as P₂O₅, bismuth oxides, such as Bi₂O₃, or combinations thereof. Preferred group VI oxides in this context are tellurium oxides, such as TeO₂, or TeO₃, selenium oxides, such as SeO₂, or combinations thereof. Preferred rare earth oxides are cerium oxides, such as CeO₂ and lanthanum oxides, such as La₂O₃. Other preferred oxides in this context are silicon oxides, such as SiO₂, zinc oxides, such as ZnO, aluminum oxides, such as Al₂O₃, germanium oxides, such as GeO₂, vanadium oxides, such as V₂O₅, niobium oxides, such as Nb₂O₅, boron oxide, tungsten oxides, such as WO₃, molybdenum oxides, such as MoO₃, and indium oxides, such as In₂O₃, further oxides of those elements listed above as preferred elements, or combinations thereof. Mixed oxides containing at least two of the elements listed as preferred elemental constituents of the glass frit, or mixed oxides which are formed by heating at least one of the above named oxides with at least one of the above named metals may also be used. Mixtures of at least two of the above-listed oxides and mixed oxides may also be used in the context of the invention.

According to one embodiment of the invention, the glass frit must have a glass transition temperature (Tg) below the desired firing temperature of the electroconductive paste. Preferred glass frits have a Tg in a range from about 250 °C to about 750 °C, preferably in a range from about 300 °C to about 700 °C, and most preferably in a range from about 350 °C to about 650 °C, when measured using thermomechanical analysis.

It is well known in the art that glass frit particles can exhibit a variety of shapes, surface natures, sizes, surface area to volume ratios and coating layers. A large number of shapes of glass frit particles are known to the person skilled in the art. Some examples include spherical, angular, elongated (rod or needle like), and flat (sheet like). Glass frit particles may also be present as a combination of particles of different shapes. Glass frit particles with a shape, or combination of shapes, which favor advantageous adhesion of the produced electrode are preferred according to the invention.

The median particle diameter d₅₀ is a characteristic of particles well known to the person skilled in the art. D₅₀ is the median diameter or the medium value of the particle size distribution. It is the value of the particle diameter at 50% in the cumulative distribution. Particle size distribution may be measured via laser diffraction, dynamic light scattering, imaging, electrophoretic light scattering, or any other method known in the art. A Horiba LA-910 Laser Diffraction Particle Size Analyzer connected to a computer with the LA-910 software program is used to determine the particle size distribution of the glass frit. The relative refractive index of the glass frit particle is chosen from the LA-910 manual and entered into the software program. The test chamber is filled with deionized water to the proper fill line on the tank. The solution is then circulated by using the circulation and agitation functions in the software program. After one minute, the solution is drained. This is repeated an additional time to ensure the chamber is clean of any residual material. The chamber is then filled with deionized water for a third time and allowed to circulate and agitate for one minute. Any background particles in the solution are eliminated by using the blank function in the software. Ultrasonic agitation is then started, and the glass frit is slowly added to the solution in the test chamber until the transmittance bars are in the proper zone in the software program. Once the transmittance is at the correct level, the laser diffraction analysis is run and the particle size distribution of the glass frit is measured and given as d50. In a preferred embodiment, the median particle diameter d₅₀ of the glass frit lies in a range from about 0.1 to about 10 µm, preferably in a range from about 0.1 to about 5 µm, more preferably in a range from about 0.1 to about 2 µm, and most preferably about 0.1 to about 1 µm.

The glass frit particles may be present with a surface coating. Any such coating known in the art and suitable in the context of the invention can be employed on the glass frit particles. Preferred coatings according to the invention are those coatings which promote improved adhesion characteristics of the electroconductive paste. If such a coating is present, it is preferred for that coating to correspond to about 0.01-10 wt%, preferably about 0.01-8 wt%, about 0.01-5 wt%, about 0.01-3 wt%, and most preferably about 0.01-1 wt%, in each case based on the total weight of the glass frit particles.

In one embodiment according to the invention, the electroconductive paste comprises about 0.01-10 wt% glass frit, preferably about 0.01-7 wt%, more preferably about 0.01-6 wt% and most preferably about 0.01-5 wt%, based upon 100% total weight of the paste. In some cases, glass frit proportions as low as about 0.02 wt% have been employed in electroconductive pastes.

### Conductive Metallic Particles

The electroconductive backside paste of the invention also comprises conductive metallic particles. Metallic particles are well known in the art. Preferred metallic particles in the context of the invention are those which exhibit conductivity and which yield soldering pads with high adhesion and low series and rear grid resistance. All metallic particles known in the art, and which are considered suitable in the context of the invention, may be employed as the metallic particles in the electroconductive paste. Preferred metallic particles according to the invention are elemental metals, alloys, metal derivatives, mixtures of at least two metals, mixtures of at least two alloys or mixtures of at least one metal with at least one alloy.

Preferred metals include at least one of silver, aluminum, gold and nickel, and alloys or mixtures thereof. In a preferred embodiment, the metallic particles comprise silver. In another preferred embodiment, the metallic particles comprise silver and aluminum. Suitable silver derivatives include, for example, silver alloys and/or silver salts, such as silver halides (e.g., silver chloride), silver nitrate, silver acetate, silver trifluoroacetate, silver orthophosphate, and combinations thereof. In one embodiment, the metallic particles comprise a metal or alloy coated with one or more different metals or alloys, for example silver particles coated with aluminum.

As additional constituents of the metallic particles, further to the above-mentioned constituents, those constituents which contribute to more favorable contact properties, adhesion, and electrical conductivity are preferred according to the invention. For example, the metallic particles may be present with a surface coating. Any such coating known in the art, and which is considered to be suitable in the context of the invention, may be employed on the metallic particles. Preferred coatings according to the invention are those coatings which promote the adhesion characteristics of the resulting electroconductive paste. If such a coating is present, it is preferred according to the invention for that coating to correspond to about 0.01-10 wt%, preferably about 0.01-8 wt%, most preferably about 0.01-5 wt%, based on 100% total weight of the metallic particles.

The metallic particles can exhibit a variety of shapes, surfaces, sizes, surface area to volume ratios, oxygen content and oxide layers. A large number of shapes are known in the art. Some examples are spherical, angular, elongated (rod or needle like) and flat (sheet like).
Metallic particles may also be present as a combination of particles of different shapes. Metallic particles with a shape, or combination of shapes, which favor adhesion are preferred according to the invention. One way to characterize such shapes without considering the surface nature of the particles is through the following parameters: length, width and thickness. In the context of the invention, the length of a particle is given by the length of the longest spatial displacement vector, both endpoints of which are contained within the particle. The width of a particle is given by the length of the longest spatial displacement vector perpendicular to the length vector defined above both endpoints of which are contained within the particle. The thickness of a particle is given by the length of the longest spatial displacement vector perpendicular to both the length vector and the width vector, both defined above, both endpoints of which are contained within the particle.

In a preferred embodiment, metallic particles with shapes as uniform as possible are used (i.e. shapes in which the ratios relating the length, the width and the thickness are as close as possible to 1, preferably all ratios lying in a range from about 0.7 to about 1.5, more preferably in a range from about 0.8 to about 1.3 and most preferably in a range from about 0.9 to about 1.2). Examples of preferred shapes for the metallic particles in this embodiment are spheres and cubes, or combinations thereof, or combinations of one or more thereof with other shapes.

In another embodiment, metallic particles which have a shape of low uniformity are used, with at least one of the ratios relating the dimensions of length, width and thickness being above about 1.5, more preferably above about 3 and most preferably above about 5. Preferred shapes according to this embodiment are flake shaped, rod or needle shaped, or a combination of flake shaped, rod or needle shaped with other shapes.

It is preferred according to the invention that the median particle diameter d₅₀, as set forth herein, of the metallic particles lie in a range from about 0.1 to about 4 µm, preferably in a range from about 0.1 to about 3 µm, more preferably in a range from about 0.1 µm to about 2 µm, and most preferably from about 0.1 to about 1 µm.

Further, preferable metallic particles have a specific surface area ranging from about 1 to about 3 m²/g. According to a preferred embodiment, silver powders having a specific surface area of about 2 - 3 m²/g are used. According to another embodiment, silver flakes having a specific surface area of about 1.5-2.7 m²/g are used. Methods of measuring specific surface area are known in the art. As set forth herein, all surface area measurements were performed using the BET (Brunauer-Emmett-Teller) method on a Horiba SA-9600 Specific Surface Area Analyzer. The metallic particle sample is loaded into the bottom cylinder of a U-tube until it is approximately one half full. The mass of sample loaded into the U-tube is then measured. This U-tube is mounted into the instrument and degassed for 15 minutes at 140°C using a 30% nitrogen/balance helium gas. Once the sample is degassed, it is mounted into the analysis station. Liquid nitrogen is then used to fill the sample dewar baths, and the surface adsorption and desportion curves are measured by the machine. Once the surface area is determined by the analyzer, the specific surface area is calculated by dividing this value by the mass of the metallic particle sample used to fill the U-tube.

The metallic conductive particles are typically about 35-70 wt%, based upon 100 total weight of the paste. In another embodiment, the conductive particles are about 30-60 wt%. In yet another embodiment, the conductive particles are about 30-50 wt% of paste. While lower metallic particle content decreases the adhesion of the resulting paste, as discussed above, it also lowers the cost of manufacturing the resulting paste.

### Organic Vehicle

Preferred organic vehicles in the context of the invention are solutions, emulsions or dispersions based on one or more solvents, preferably an organic solvent, which ensure that the constituents of the electroconductive paste are present in a dissolved, emulsified or dispersed form. Preferred organic vehicles are those which provide optimal stability of constituents within the electroconductive paste and endow the electroconductive paste with a viscosity allowing effective printability.

In one embodiment, the organic vehicle comprises an organic solvent and one or more of a binder (e.g., a polymer), a surfactant and a thixotropic agent, or any combination thereof. For example, in one embodiment, the organic vehicle comprises one or more binders in an organic solvent.

Preferred binders in the context of the invention are those which contribute to the formation of an electroconductive paste with favorable stability, printability, viscosity and sintering properties. Binders are well known in the art. All binders which are known in the art, and which are considered to be suitable in the context of this invention, can be employed as the binder in the organic vehicle. Preferred binders according to the invention (which often fall within the category termed "resins") are polymeric binders, monomeric binders, and binders which are a combination of polymers and monomers. Polymeric binders can also be copolymers wherein at least two different monomeric units are contained in a single molecule. Preferred polymeric binders are those which carry functional groups in the polymer main chain, those which carry functional groups off of the main chain and those which carry functional groups both within the main chain and off of the main chain. Preferred polymers carrying functional groups in the main chain are for example polyesters, substituted polyesters, polycarbonates, substituted polycarbonates, polymers which carry cyclic groups in the main chain, poly-sugars, substituted poly-sugars, polyurethanes, substituted polyurethanes, polyamides, substituted polyamides, phenolic resins, substituted phenolic resins, copolymers of the monomers of one or more of the preceding polymers, optionally with other co-monomers, or a combination of at least two thereof. According to one embodiment, the binder may be polyvinyl butyral or polyethylene. Preferred polymers which carry cyclic groups in the main chain are for example polyvinylbutylate (PVB) and its derivatives and poly-terpineol and its derivatives or mixtures thereof. Preferred poly-sugars are for example cellulose and alkyl derivatives thereof, preferably methyl cellulose, ethyl cellulose, hydroxyethyl cellulose, propyl cellulose, hydroxypropyl cellulose, butyl cellulose and their derivatives and mixtures of at least two thereof. Other preferred polymers are cellulose ester resins, e.g., cellulose acetate propionate, cellulose acetate buyrate, and any combinations thereof. Preferred polymers which carry functional groups off of the main polymer chain are those which carry amide groups, those which carry acid and/or ester groups, often called acrylic resins, or polymers which carry a combination of aforementioned functional groups, or a combination thereof. Preferred polymers which carry amide off of the main chain are for example polyvinyl pyrrolidone (PVP) and its derivatives. Preferred polymers which carry acid and/or ester groups off of the main chain are for example polyacrylic acid and its derivatives, polymethacrylate (PMA) and its derivatives or polymethylmethacrylate (PMMA) and its derivatives, or a mixture thereof. Preferred monomeric binders according to the invention are ethylene glycol based monomers, terpineol resins or rosin derivatives, or a mixture thereof. Preferred monomeric binders based on ethylene glycol are those with ether groups, ester groups or those with an ether group and an ester group, preferred ether groups being methyl, ethyl, propyl, butyl, pentyl hexyl and higher alkyl ethers, the preferred ester group being acetate and its alkyl derivatives, preferably ethylene glycol monobutylether monoacetate or a mixture thereof. Alkyl cellulose, preferably ethyl cellulose, its derivatives and mixtures thereof with other binders from the preceding lists of binders or otherwise are the most preferred binders in the context of the invention. The binder may be present in an amount between about 0.1 and 10 wt%, preferably between about 0.1-8 wt%, more preferably between about 0.5-7 wt%, based upon 100% total weight of the organic vehicle.

Preferred solvents according to the invention are constituents of the electroconductive paste which are removed from the paste to a significant extent during firing, preferably those which are present after firing with an absolute weight reduced by at least about 80% compared to before firing, preferably reduced by at least about 95% compared to before firing. Preferred solvents according to the invention are those which allow an electroconductive paste to be formed which has favorable viscosity, printability, stability and sintering characteristics. Solvents are well known in the art. All solvents which are known in the art, and which are considered to be suitable in the context of this invention, may be employed as the solvent in the organic vehicle. According to the invention, preferred solvents are those which allow the preferred high level of printability of the electroconductive paste as described above to be achieved. Preferred solvents according to the invention are those which exist as a liquid under standard ambient temperature and pressure (SATP) (298.15 K, 25 °C, 77 °F), 100 kPa (14.504 psi, 0.986 atm), preferably those with a boiling point above about 90 °C and a melting point above about -20 °C. Preferred solvents according to the invention are polar or non-polar, protic or aprotic, aromatic or non-aromatic. Preferred solvents according to the invention are mono-alcohols, di-alcohols, poly-alcohols, mono-esters, di-esters, poly-esters, mono-ethers, diethers, poly-ethers, solvents which comprise at least one or more of these categories of functional group, optionally comprising other categories of functional group, preferably cyclic groups, aromatic groups, unsaturated bonds, alcohol groups with one or more O atoms replaced by heteroatoms, ether groups with one or more O atoms replaced by heteroatoms, esters groups with one or more O atoms replaced by heteroatoms, and mixtures of two or more of the aforementioned solvents. Preferred esters in this context are di-alkyl esters of adipic acid, preferred alkyl constituents being methyl, ethyl, propyl, butyl, pentyl, hexyl and higher alkyl groups or combinations of two different such alkyl groups, preferably dimethyladipate, and mixtures of two or more adipate esters. Preferred ethers in this context are diethers, preferably dialkyl ethers of ethylene glycol, preferred alkyl constituents being methyl, ethyl, propyl, butyl, pentyl, hexyl and higher alkyl groups or combinations of two different such alkyl groups, and mixtures of two diethers. Preferred alcohols in this context are primary, secondary and tertiary alcohols, preferably tertiary alcohols, terpineol and its derivatives being preferred, or a mixture of two or more alcohols. Preferred solvents which combine more than one different functional groups are 2,2,4-trimethyl-1,3-pentanediol monoisobutyrate, often called texanol, and its derivatives, 2-(2-ethoxyethoxy)ethanol, often known as carbitol, its alkyl derivatives, preferably methyl, ethyl, propyl, butyl, pentyl, and hexyl carbitol, preferably hexyl carbitol or butyl carbitol, and acetate derivatives thereof, preferably butyl carbitol acetate, or mixtures of at least two of the aforementioned. The organic solvent may be present in an amount between about 40 and 90 wt%, more preferably between about 35 and 85 wt%, based upon 100% total weight of the organic vehicle.

The organic vehicle may also comprise a surfactant and/or additives. Preferred surfactants in the context of the invention are those which contribute to the formation of an electroconductive paste with favorable stability, printability, viscosity and sintering properties. Surfactants are well known to the person skilled in the art. All surfactants which are known in the art, and which are considered to be suitable in the context of this invention, may be employed as the surfactant in the organic vehicle. Preferred surfactants in the context of the invention are those based on linear chains, branched chains, aromatic chains, fluorinated chains, siloxane chains, polyether chains and combinations thereof. Preferred surfactants are single chained, double chained or poly chained. Preferred surfactants according to the invention may have nonionic, anionic, cationic, amphiphilic, or zwitterionic heads. Preferred surfactants are polymeric and monomeric or a mixture thereof. Preferred surfactants according to the invention can have pigment affinic groups, preferably hydroxyfunctional carboxylic acid esters with pigment affinic groups (e.g., DISPERBYK®-108, manufactured by BYK USA, Inc.), acrylate copolymers with pigment affinic groups (e.g., DISPERBYK®-116, manufactured by BYK USA, Inc.), modified polyethers with pigment affinic groups (e.g., TEGO® DISPERS 655, manufactured by Evonik Tego Chemie GmbH), other surfactants with groups of high pigment affinity (e.g., TEGO® DISPERS 662 C, manufactured by Evonik Tego Chemie GmbH). Other preferred polymers according to the invention not in the above list are polyethylene oxide, polyethylene glycol and its derivatives, and alkyl carboxylic acids and their derivatives or salts, or mixtures thereof. The preferred polyethylene glycol derivative according to the invention is poly(ethyleneglycol)acetic acid. Preferred alkyl carboxylic acids are those with fully saturated and those with singly or poly unsaturated alkyl chains or mixtures thereof. Preferred carboxylic acids with saturated alkyl chains are those with alkyl chains lengths in a range from about 8 to about 20 carbon atoms, preferably C₉H₁₉COOH (capric acid), C₁₁H₂₃COOH (Lauric acid), C₁₃H₂₇COOH (myristic acid) C₁₅H₃₁COOH (palmitic acid), C₁₇H₃₅COOH (stearic acid), or salts or mixtures thereof. Preferred carboxylic acids with unsaturated alkyl chains are C₁₈H₃₄O₂ (oleic acid) and C₁₈H₃₂O₂ (linoleic acid). The preferred monomeric surfactant according to the invention is benzotriazole and its derivatives. The surfactant may be present in an amount of about 0 to 10 wt%, preferably about 0-8 wt%, and more preferably about 0.01-6 wt%, based upon 100% total weight of the organic vehicle.

Preferred additives in the organic vehicle are those additives which are distinct from the aforementioned vehicle components and which contribute to favorable properties of the electroconductive paste, such as advantageous viscosity and adhesion to the underlying substrate. Additives known in the art, and which are considered to be suitable in the context of the invention, may be employed as an additive in the organic vehicle. Preferred additives according to the invention are thixotropic agents, viscosity regulators, stabilizing agents, inorganic additives, thickeners, emulsifiers, dispersants or pH regulators. Preferred thixotropic agents in this context are carboxylic acid derivatives, preferably fatty acid derivatives or combinations thereof. Preferred fatty acid derivatives are C₉H₁₉COOH (capric acid), C₁₁H₂₃COOH (Lauric acid), C₁₃H₂₇COOH (myristic acid) C₁₅H₃₁COOH (palmitic acid), C₁₇H₃₅COOH (stearic acid) C₁₈H₃₄O₂ (oleic acid), C₁₈H₃₂O₂ (linoleic acid) or combinations thereof. A preferred combination comprising fatty acids in this context is castor oil.

In one embodiment, the organic vehicle is present in an amount of about 20-60 wt%, more preferably about 30-50 wt%, and most preferably about 40-50 wt%, based upon 100% total weight of the paste.

### Adhesion Enhancer

The paste may further comprise an adhesion enhancer to improve its adhesive strength. The adhesion enhancer may comprise at least one metal selected from the group consisting of tellurium (Te), tungsten (W), molybdenum (Mo), vanadium (V), antimony (Sb), magnesium (Mg), zirconium (Zr), silver (Ag), cobalt (Co), nickel (Ni), cerium (Ce) and zinc (Zn). According to another embodiment, the adhesion enhancer may comprise at least one of the following metal oxides: tellurium dioxide (TeO₂), nickel oxide (NiO), magnesium oxide (MgO), zirconium dioxide (ZrO₂), tungsten oxide (WO₃), silver oxide (AgO), cobalt oxide (CoO) and cerium oxide (CeO₂).

Preferably, the adhesion enhancer comprises tellurium and/or tellurium dioxide. The adhesion enhancer may be dispersed within the glass frit, or within the paste composition independent from the glass frit. When the adhesion enhancer comprises tellurium dioxide, the median particle size d₅₀ is preferably less than 1 µm, preferably less than 0.6 µm. As a general observation, without limiting the scope of the invention, smaller tellurium oxide particle size aids the distribution within the paste composition and provides better adhesive and electrical properties.

In a preferred embodiment, the paste comprises approximately 0.01-5 wt% of adhesion enhancer, preferably about 0.05-2.5 wt%, more preferably about 0.05-1 wt%, based upon 100% total weight of the paste.

### Additives

Preferred additives in the context of the invention are constituents added to the electroconductive paste, in addition to the other constituents explicitly mentioned, which contribute to increased performance of the electroconductive paste, of the soldering pads produced thereof, or of the resulting solar cell. All additives known in the art, and which are considered suitable in the context of the invention, may be employed as additives in the electroconductive paste. In addition to additives present in the glass frit and in the vehicle, additives can also be present in the electroconductive paste. Preferred additives according to the invention are thixotropic agents, viscosity regulators, emulsifiers, stabilizing agents or pH regulators, inorganic additives, thickeners and dispersants, or a combination of at least two thereof, whereas inorganic additives are most preferred. Preferred inorganic additives in this context according to the invention are Mg, Ni, Te, W, Zn, Mg, Gd, Ce, Zr, Ti, Mn, Sn, Ru, Co, Fe, Cu and Cr or a combination of at least two thereof, preferably Zn, Sb, Mn, Ni, W, Te and Ru, or a combination of at least two thereof, oxides thereof, compounds which can generate those metal oxides on firing, or a mixture of at least two of the aforementioned metals, a mixture of at least two of the aforementioned oxides, a mixture of at least two of the aforementioned compounds which can generate those metal oxides on firing, or mixtures of two or more of any of the above mentioned.

According to one embodiment, the electroconductive paste composition, in addition to the glass frit, metallic particles, and organic vehicle, further comprises metal or metal oxides formed from copper, aluminum, bismuth, zinc, lithium, and tellurium. In a preferred embodiment, metallic compounds such as aluminum-silicon compounds, aluminum-phosphorus compounds, and copper compounds are added to improve the overall adhesive properties of the electroconductive paste. Such additives may be present in an amount of about 0.01-1 wt%, based upon 100% total weight of the paste.

### Forming the Electroconductive Paste Composition

To form the electroconductive paste composition, the glass frit materials may be combined with the metallic particles and the organic vehicle using any method known in the art for preparing a paste composition. The method of preparation is not critical, as long as it results in a homogenously dispersed paste. The components can be mixed, such as with a mixer, then passed through a three roll mill, for example, to make a dispersed uniform paste.

### Solar Cells

In another aspect, the invention relates to a solar cell. In one embodiment, the solar cell comprises a semiconductor substrate (e.g., a silicon wafer) and an electroconductive paste composition according to any of the embodiments described herein.

In another aspect, the invention relates to a solar cell prepared by a process comprising applying an electroconductive paste composition according to any of the embodiments described herein to a semiconductor substrate (such as a silicon wafer) and firing the semiconductor substrate.

### Silicon Wafer

Preferred wafers according to the invention have regions, among other regions of the solar cell, capable of absorbing light with high efficiency to yield electron-hole pairs and separating holes and electrons across a boundary with high efficiency, preferably across a p-n junction boundary. Preferred wafers according to the invention are those comprising a single body made up of a front doped layer and a back doped layer.

Preferably, the wafer consists of appropriately doped tetravalent elements, binary compounds, tertiary compounds or alloys. Preferred tetravalent elements in this context are Silicon, Ge or Sn, preferably Silicon. Preferred binary compounds are combinations of two or more tetravalent elements, binary compounds of a group III element with a group V element, binary com-pounds of a group II element with a group VI element or binary compounds of a group IV element with a group VI element. Preferred combinations of tetravalent elements are combinations of two or more elements selected from Silicon, Ge, Sn or C, preferably SiC. The preferred binary compounds of a group III element with a group V element is GaAs. According to a preferred embodiment of the invention, the wafer is silicon. The foregoing description, in which silicon is explicitly mentioned, also applies to other wafer compositions described herein.

The p-n junction boundary is located where the front doped layer and back doped layer of the wafer meet. In an n-type solar cell, the back doped layer is doped with an electron donating n-type dopant and the front doped layer is doped with an electron accepting or hole donating p-type dopant. In a p-type solar cell, the back doped layer is doped with p-type dopant and the front doped layer is doped with n-type dopant. According to a preferred embodiment of the invention, a wafer with a p-n junction boundary is prepared by first providing a doped silicon substrate and then applying a doped layer of the opposite type to one face of that substrate.

Doped silicon substrates are well known in the art. The doped silicon substrate can be prepared by any method known in the art and considered suitable for the invention. Preferred sources of silicon substrates according to the invention are mono-crystalline silicon, multi-crystalline silicon, amorphous silicon and upgraded metallurgical silicon, most preferably mono-crystalline silicon or multi-crystalline silicon. Doping to form the doped silicon substrate can be carried out simultaneously by adding the dopant during the preparation of the silicon substrate, or it can be carried out in a subsequent step. Doping subsequent to the preparation of the silicon substrate can be carried out by gas diffusion epitaxy, for example. Doped silicon substrates are also readily commercially available. According to one embodiment, the initial doping of the silicon substrate may be carried out simultaneously to its formation by adding dopant to the silicon mix. According to another embodiment, the application of the front doped layer and the highly doped back layer, if present, may be carried out by gas-phase epitaxy. This gas phase epitaxy is preferably carried out within a temperature range of about 500 °C to about 900 °C, more preferably from about 600 °C to about 800 °C, and most preferably from about 650 °C to about 750 °C, at a pressure in a range from about 2 kPa to about 100 kPa, preferably from about 10 to about 80 kPa, most preferably from about 30 to about 70 kPa.

It is known in the art that silicon substrates can exhibit a number of shapes, surface textures and sizes. The shape of the substrate may include cuboid, disc, wafer and irregular polyhedron, to name a few. According to a preferred embodiment of the invention, the wafer is a cuboid with two dimensions which are similar, preferably equal, and a third dimension which is significantly smaller than the other two dimensions. The third dimension may be at least 100 times smaller than the first two dimensions.

Further, a variety of surface types are known in the art. According to the invention, silicon substrates with rough surfaces are preferred. One way to assess the roughness of the substrate is to evaluate the surface roughness parameter for a sub-surface of the substrate, which is small in comparison to the total surface area of the substrate, preferably less than about one hundredth of the total surface area, and which is essentially planar. The value of the surface roughness parameter is given by the ratio of the area of the sub-surface to the area of a theoretical surface formed by projecting that sub-surface onto the flat plane best fitted to the sub-surface by minimizing mean square displacement. A higher value of the surface roughness parameter indicates a rougher, more irregular surface and a lower value of the surface roughness parameter indicates a smoother, more even surface. According to the invention, the surface roughness of the silicon substrate is preferably modified so as to produce an optimum balance between a number of factors including, but not limited to, light absorption and adhesion to the surface.

The two larger dimensions of the silicon substrate can be varied to suit the application required of the resultant solar cell. It is preferred according to the invention for the thickness of the silicon wafer to be about 0.01-0.5 mm, more preferably about 0.01-0.3 mm, and most preferably about 0.01-0.2 mm. Some wafers have a minimum thickness of 0.01 mm.

It is preferred according to the invention that the front doped layer be thin in comparison to the back doped layer. It is also preferred that the front doped layer have a thickness lying in a range from about 0.1 to about 10 µm, preferably in a range from about 0.1 to about 5 µm and most preferably in a range from about 0.1 to about 2 µm.

A highly doped layer can be applied to the back face of the silicon substrate between the back doped layer and any further layers. Such a highly doped layer is of the same doping type as the back doped layer and such a layer is commonly denoted with a + (n+-type layers are applied to n-type back doped layers and p+-type layers are applied to p-type back doped layers). This highly doped back layer serves to assist metallization and improve electroconductive properties. It is preferred according to the invention for the highly doped back layer, if present, to have a thickness in a range from about 1 to about 100 µm, preferably in a range from about 1 to about 50 µm and most preferably in a range from about 1 to about 15 µm.

### Dopants

Preferred dopants are those which, when added to the silicon wafer, form a p-n junction boundary by introducing electrons or holes into the band structure. It is preferred according to the invention that the identity and concentration of these dopants is specifically selected so as to tune the band structure profile of the p-n junction and set the light absorption and conductivity profiles as required. Preferred p-type dopants according to the invention are those which add holes to the silicon wafer band structure. All dopants known in the art and which are considered suitable in the context of the invention can be employed as p-type dopants. Preferred p-type dopants according to the invention are trivalent elements, particularly those of group 13 of the periodic table. Preferred group 13 elements of the periodic table in this context include, but are not limited to, B, Al, Ga, In, Tl, or a combination of at least two thereof, wherein B is particularly preferred.

Preferred n-type dopants according to the invention are those which add electrons to the silicon wafer band structure. All dopants known in the art and which are considered to be suitable in the context of the invention can be employed as n-type dopants. Preferred n-type dopants according to the invention are elements of group 15 of the periodic table. Preferred group 15 elements of the periodic table in this context include N, P, As, Sb, Bi or a combination of at least two thereof, wherein P is particularly preferred.

As described above, the various doping levels of the p-n junction can be varied so as to tune the desired properties of the resulting solar cell.

According to certain embodiments, the semiconductor substrate (i.e., silicon wafer) exhibits a sheet resistance above about 60 Ω/□, such as above about 65 Ω/□, 70 Ω/□, 90 Ω/□ or 95 Ω/□.

### Solar Cell Structure

A contribution to achieving at least one of the above described objects is made by a solar cell obtainable from a process according to the invention. Preferred solar cells according to the invention are those which have a high efficiency, in terms of proportion of total energy of incident light converted into electrical energy output, and those which are light and durable. At a minimum, a solar cell includes: (i) front electrodes, (ii) a front doped layer, (iii) a p-n junction boundary, (iv) a back doped layer, and (v) soldering pads. The solar cell may also include additional layers for chemical/mechanical protection.

### Antireflective Layer

According to the invention, an antireflective layer may be applied as the outer layer before the electrode is applied to the front face of the solar cell. Preferred antireflective layers according to the invention are those which decrease the proportion of incident light reflected by the front face and increase the proportion of incident light crossing the front face to be absorbed by the wafer. Antireflective layers which give rise to a favorable absorption/reflection ratio, are susceptible to etching by the electroconductive paste, are otherwise resistant to the temperatures required for firing of the electroconductive paste, and do not contribute to increased recombination of electrons and holes in the vicinity of the electrode interface are preferred. All antireflective layers known in the art and which are considered to be suitable in the context of the invention can be employed. Preferred antireflective layers according to the invention are SiNₓ, SiO₂, Al₂O₃, TiO₂ or mixtures of at least two thereof and/or combinations of at least two layers thereof. According to a preferred embodiment, the antireflective layer is SiNₓ, in particular where a silicon wafer is employed.

The thickness of antireflective layers is suited to the wavelength of the appropriate light. According to a preferred embodiment of the invention, the antireflective layers have a thickness in a range from about 20 to about 300 nm, more preferably in a range from about 40 to about 200 nm, and most preferably in a range from about 60 to about 90 nm.

### Passivation Layers

According to the invention, one or more passivation layers may be applied to the front and/or back side of the silicon wafer as an outer layer. The passivation layer(s) may be applied before the front electrode is formed, or before the antireflective layer is applied (if one is present). Preferred passivation layers are those which reduce the rate of electron/hole recombination in the vicinity of the electrode interface. Any passivation layer which is known in the art and which is considered to be suitable in the context of the invention can be employed. Preferred passivation layers according to the invention are silicon nitride, silicon dioxide and titanium dioxide. According to a most preferred embodiment, silicon nitride is used. It is preferred for the passivation layer to have a thickness in a range from about 0.1 nm to about 2 µm, more preferably in a range from about 10 nm to about 1 µm, and most preferably in a range from about 30 nm to about 200 nm.

### Additional Protective Layers

In addition to the layers described above which directly contribute to the principle function of the solar cell, further layers can be added for mechanical and chemical protection.

The cell can be encapsulated to provide chemical protection. Encapsulations are well known in the art and any encapsulation suitable for the invention can be employed. According to a preferred embodiment, transparent polymers, often referred to as transparent thermoplastic resins, are used as the encapsulation material, if such an encapsulation is present. Preferred transparent polymers in this context are silicon rubber and polyethylene vinyl acetate (PVA).

A transparent glass sheet may also be added to the front of the solar cell to provide mechanical protection to the front face of the cell. Transparent glass sheets are well known in the art and any transparent glass sheet suitable in the context of the invention may be employed.

A back protecting material may be added to the back face of the solar cell to provide mechanical protection. Back protecting materials are well known in the art and any back protecting material considered suitable in the context of the invention may be employed. Preferred back protecting materials according to the invention are those having good mechanical properties and weather resistance. The preferred back protection material according to the invention is polyethylene terephthalate with a layer of polyvinyl fluoride. It is preferred according to the invention for the back protecting material to be present underneath the encapsulation layer (in the event that both a back protection layer and encapsulation are present).

A frame material can be added to the outside of the solar cell to give mechanical support. Frame materials are well known in the art and any frame material considered suitable in the context of the invention may be employed. The preferred frame material according to the invention is aluminum.

### Method of Preparing Solar Cell

A solar cell may be prepared by applying an electroconductive paste composition to an antireflective coating, such as silicon nitride, silicon oxide, titanium oxide or aluminum oxide, on the front side of a semiconductor substrate, such as a silicon wafer. The backside electroconductive paste of the invention is then applied to the backside of the solar cell to form soldering pads. The electroconductive pastes may be applied in any manner known in the art and considered suitable in the context of the invention. Examples include, but are not limited to, impregnation, dipping, pouring, dripping on, injection, spraying, knife coating, curtain coating, brushing or printing or a combination of at least two thereof. Preferred printing techniques are ink-jet printing, screen printing, tampon printing, offset printing, relief printing or stencil printing or a combination of at least two thereof. It is preferred according to the invention that the electroconductive paste is applied by printing, preferably by screen printing. An aluminum paste is then applied to the backside of the substrate, overlapping the edges of the soldering pads formed from the backside electroconductive paste, to form the BSF. The substrate is then fired according to an appropriate profile.

Firing is necessary to sinter the printed soldering pads so as to form solid conductive bodies. Firing is well known in the art and can be effected in any manner considered suitable in the context of the invention. It is preferred that firing be carried out above the Tg of the glass frit materials.

According to the invention, the maximum temperature set for firing is below about 900 °C, preferably below about 860 °C. Firing temperatures as low as about 820 °C have been employed for obtaining solar cells. The firing temperature profile is typically set so as to enable the burnout of organic binder materials from the electroconductive paste composition, as well as any other organic materials present. The firing step is typically carried out in air or in an oxygen-containing atmosphere in a belt furnace. It is preferred according to the invention for firing to be carried out in a fast firing process with a total firing time in the range from about 30 s to about 3 minutes, more preferably in the range from about 30 s to about 2 minutes, and most preferably in the range from about 40 seconds to about 1 minute. The time above 600 °C is most preferably in a range from about 3 to 7 seconds. The substrate may reach a peak temperature in the range of about 700 to 900° C for a period of about 1 to 5 seconds. The firing may also be conducted at high transport rates, for example, about 100-500 cm/min, with resulting hold-up times of about 0.05 to 5 minutes. Multiple temperature zones, for example 3-12 zones, can be used to control the desired thermal profile.

Firing of electroconductive pastes on the front and back faces can be carried out simultaneously or sequentially. Simultaneous firing is appropriate if the electroconductive pastes applied to both faces have similar, preferably identical, optimum firing conditions. Where appropriate, it is preferred according to the invention for firing to be carried out simultaneously. Where firing is carried out sequentially, it is preferable according to the invention for the back electroconductive paste to be applied and fired first, followed by application and firing of the electroconductive paste to the front face.

### Measuring Conductivity and Adhesion Performance

One method used to measure the adhesive strength, also known as the pull force, of the resulting electroconductive paste is to apply a solder wire to the electroconductive paste layer (soldering pad) which has been printed on the backside of a silicon solar cell. A standard soldering wire is applied to the soldering pad either by an automated machine, such as Somont Cell Connecting automatic soldering machine (manufactured by Meyer Burger Technology Ltd.), or manually with a hand held solder gun according to methods known in the art. In the invention, a 0.20 x 0.20 mm copper ribbon with approximately 20 µm 62/36/2 solder coating was used, although other methods common in the industry and known in the art may be used. Specifically, a length of ribbon approximately 2.5 times the length of the solar cell is cut. A solder flux is coated onto the cut ribbon and allowed to dry for 1-5 minutes. The cell is then mounted into the soldering fixture and the ribbon is aligned on top of the cell busbar. The soldering fixture is loaded onto the preheat stage and the cell is preheated for 15 seconds at 150-180°C. After preheat, the soldering pins are lowered and the ribbon is soldered onto the busbar for 0.8-1.8 seconds at 220-250°C. With the copper wire soldered to the length of the soldering pad, the adhesion force is measured using a pull-tester such as GP Solar GP PULL-TEST Advanced. A tailing end of the soldered ribbon is attached to the force gauge on the pull-tester and peeled back at approximately 180° at a constant speed of 6 mm/s. The force gauge records the adhesive force in Newtons at a sampling rate of 100 s⁻¹.

When evaluating exemplary pastes, this solder and pull process is typically completed four times on four separate backside soldering pads to minimize variation in the data that normally results from the soldering process. One individual measurement from one experiment is not highly reliable, as discrete variations in the soldering process can affect the results. Therefore, an overall average from four pulls is obtained and the averaged pull forces are compared between pastes. A minimum of 1 Newton pull force is desirable. The acceptable industry standard for adhesive strength is typically above 2 Newtons. Stronger adhesion with a pull force of at least 3 Newtons, or in some instances, greater than 5 Newtons is most desirable.

When evaluating the contact resistance of an exemplary backside paste, a standard electrical performance test is conducted. A sample solar cell having both frontside and backside pastes printed thereon is characterized using a commercial IV-tester "cetisPV-CTL1" from Halm Elektronik GmbH. All parts of the measurement equipment as well as the solar cell to be tested are maintained at 25 °C during electrical measurement. This temperature is always measured simultaneously on the cell surface during the actual measurement by a temperature probe. The Xe Arc lamp simulates the sunlight with a known AM1.5 intensity of 1000 W/m² on the cell surface. To bring the simulator to this intensity, the lamp is flashed several times within a short period of time until it reaches a stable level monitored by the "PVCTControl 4.313.0" software of the IV-tester. The Halm IV tester uses a multi-point contact method to measure current (I) and voltage (V) to determine the cell's IV-curve. To do so, the solar cell is placed between the multi-point contact probes in such a way that the probe fingers are in contact with the bus bars of the cell. The numbers of contact probe lines are adjusted to the number of bus bars on the cell surface. All electrical values are determined directly from this curve automatically by the implemented software package. As a reference standard, a calibrated solar cell from ISE Freiburg consisting of the same area dimensions, same wafer material and processed using the same front side layout is tested and the data compared to the certificated values. At least 4 wafers processed in the very same way are measured and the data interpreted by calculating the average of each value. The software PVCTControl 4.313.0 provides values for efficiency, fill factor, short circuit current, series resistance, open circuit voltage, and rear grid resistance.

### Solar Cell Module

A contribution to achieving at least one of the above mentioned objects is made by a module having at least one solar cell obtained as described above. A plurality of solar cells according to the invention can be arranged spatially and electrically interconnected to form a collective arrangement called a module. Preferred modules according to the invention can have a number of arrangements, preferably a rectangular arrangement known as a solar panel. A large variety of ways to electrically connect solar cells, as well as a large variety of ways to mechanically arrange and fix such cells to form collective arrangements, are well known in the art. Any such methods known by one skilled in the art, and which are considered suitable in the context of the invention, may be employed. Preferred methods according to the invention are those which result in a low mass to power output ratio, low volume to power output ration, and high durability. Aluminum is the preferred material for mechanical fixing of solar cells according to the invention.

### EXAMPLES

The following non-limiting examples illustrate the optimization of glass frits which contain Bi₂O₃, Al₂O₃, SiO₂, B₂O₃ and at least one of Li₂O or Li₃PO₄. The solar cells prepared from electroconductive pastes having the above-mentioned glass frits all exhibited adhesive performance well above industry standard.

### Example 1

A first set of exemplary glass compositions (referred to as G1-G8) were prepared and are set forth in Table 1 below. Glass samples were prepared in 100g batches by mixing individual oxide constituents in the proper ratios. The oxide mixture was loaded into a 8.34 in³ volume Colorado crucible. The crucible was then placed in an oven for 40 minutes at 600°C to preheat the oxide mixture. After preheat, the crucible was moved into a refractory oven at 1200°C for 20 minutes to melt the individual components into a glass mixture. The molten glass was then removed from the oven and poured into a bucket containing deionized water to quickly quench. This glass frit was further processed in a 1 L ceramic jar mill. The jar mill was filled approximately halfway with ½ cylindrical alumina media and deionized water. The glass frit was added to the jar mill and rolled for 8 hours at 60-80RPM. After milling, the glass frit was filtered through a 325 mesh sieve and dried at 125°C for 24 hours. The amount of Bi₂O₃ and Al₂O₃ was kept consistent across all exemplary glass compositions, while the amounts and types of the remaining oxides were varied. All amounts are expressed in 100% total weight of the glass.

**Table 1. Glass Compositions of Exemplary Pastes P1-P8**

| **Glass** | **G1** | **G2** | **G3** | **G4** | **G5** | **G6** | **G7** | **G8** |
|---|---|---|---|---|---|---|---|---|
| Bi₂O₃ | 82 | 82 | 82 | 82 | 82 | 82 | 82 | 82 |
| Al₂O₃ | 3 | 3 | 3 | 3 | 3 | 3 | 3 | 3 |
| SiO₂ | 1 | 1 | 4 | 4 | 4 | 5 | 10 | 10 |
| B₂O₃ | 4 | 10 | 1 | 1 | 10 | 5 | 1 | 4 |
| Li₂O | 10 | 4 | 10 | - | 1 | 5 | 4 | 1 |
| Li₃PO₄ | - | - | - | 10 | - | - | - | - |

To form each exemplary paste P1-P8, about 50 wt% silver particles, about 3 wt% of each glass composition G1-G8, about 0.1 wt% of a first adhesion enhancer (TeO₂), about 0.13 wt% of a second adhesion enhancer (ZnO), and about 47 wt% of organic vehicle, based upon 100% total weight of the paste, were combined. In this Example, a silver powder having a specific surface area of about 2-3 m²/g and a d₅₀ of about 0.2-0.3 µm was used. The specific surface area and d₅₀ values were measured according to the procedures set forth herein.

Once the pastes were mixed to a uniform consistency, they were screen printed onto the rear side of a blank monocrystalline silicon wafer using 250 mesh stainless steel, 5 µm EOM, at about a 30 µm wire diameter. The backside paste is printed to form soldering pads, which extend across the full length of the cell and are about 4 mm wide. However, different designs and screen parameters known in the art can be used. Next, a different aluminum backside paste was printed all over the remaining areas of the rear side of the cell to form an aluminum BSF. The cell was then dried at an appropriate temperature. To allow for electrical performance testing, a standard front side paste was printed on the front side of the cell in a two busbar pattern. The silicon substrate, with the printed front side and backside paste, was then fired at a temperature of approximately 700-975°C.

The adhesive strength and series and rear grid resistance of the exemplary pastes was then measured according to procedure previously described. As set forth above, a minimum of 1 Newton pull force (adhesive strength) is desirable. The acceptable industry standard for adhesive strength is typically above 2 Newtons. Stronger adhesion with a pull force of at least 3 Newtons, or in some instances, greater than 5 Newtons is most desirable. A rear grid resistance of less than 0.007 Ω is desirable in the industry.

The adhesive performance of the exemplary pastes is set forth in Table 2 below. All adhesive values are reported in Newtons and rear grid and series resistance is reported in ohms. Each of the exemplary pastes exhibited excellent adhesive performance, with the lowest pull force being 3.25 Newtons (above industry standards). Exemplary Pastes P3 and P5 exhibited the best adhesive performance, while also exhibiting acceptable rear grid and series resistance.

**Table 2. Adhesive Strength and Resistance of First Set of Exemplary Pastes P1 - P8**

| **Paste** | **P1** | **P2** | **P3** | **P4** | **P5** | **P6** | **P7** | **P8** |
|---|---|---|---|---|---|---|---|---|
| Adhesion | 3.25 | 4.97 | **6.26** | 5.71 | **6.22** | 5.09 | 4.62 | 5.61 |
| Rear Grid | 0.00636 | 0.00603 | **0.00627** | 0.00656 | **0.00617** | 0.00609 | 0.00628 | 0.00629 |
| Series R | 0.00393 | 0.00383 | **0.00409** | 0.00373 | **0.00384** | 0.00350 | 0.00359 | 0.00349 |

### Example 2

Paste P3, having Glass G3, was chosen for further optimization due to its superior adhesive strength. To ascertain the effect of varying the levels of Bi₂O₃, Al₂O₃ and Li₂O in the Glass G3, a second set of exemplary glasses (referred to as G9 and G10) was prepared by the procedures set forth in Example 1. The glass compositions are set forth in Table 3 below. All amounts are expressed in 100% total weight of the glass.

**Table 3. Glass Compositions G9 and G10**

| | **G3** | **G9** | **G10** |
|---|---|---|---|
| **Bi2O3** | 82 | 80 | 79 |
| **Al2O3** | 3 | 5 | 1 |
| **SiO2** | 4 | 4 | 4 |
| **B2O3** | 1 | 1 | 1 |
| **Li2O** | 10 | 10 | 15 |

Glasses G9 and G 10 were then combined with silver particles, various oxides, and an organic vehicle to form five exemplary pastes P9-P13, as set forth in Table 4 below. Pastes P10 and P11 incorporated glass G9, while Pastes P12 and P13 incorporated glass G10, as set forth in Table 3 below. The pastes were screen-printed, dried and fired according to the parameters set forth in Example 1.

In order to ascertain the effect of including an additive, Paste P9 was formed with Glass G3 but also included a copper additive. All values are expressed in weight percent of total paste composition.

**Table 4. Paste Compositions of Exemplary Pastes P9-P13**

| | **P3** | **P9** | **P10** | **P11** | **P12** | **P13** |
|---|---|---|---|---|---|---|
| **Silver** | 50 | 54 | 54 | 54 | 54 | 54 |
| **Glass G3** | 3 | 3 | | | | |
| **Glass G9** | | | | | 3 | 3 |
| **Glass G10** | | | 3 | 3 | | |
| **TeO2** | 0.10 | 0.10 | 0.10 | 0.10 | 0.10 | 0.10 |
| **ZnO** | 0.13 | 0.13 | 0.13 | 0.13 | 0.13 | 0.13 |
| **Cu Additive** | | 0.13 | 0.13 | | 0.13 | |
| **Vehicle** | 46.77 | 42.64 | 46.77 | 46.77 | 46.77 | 46.77 |

The adhesive strength of the exemplary pastes P9-P13 was then measured as described previously and compared to both the P3 paste as well as a commercially available paste ("Reference). As shown in Table 5, the adhesive strength of Pastes P9-P13 all performed well over acceptable industry standards, with the lowest pull force being 4.2 Newtons. Paste P 13 performed comparably to P3 and the Reference paste (within 1 Newton), while Pastes P9 and Paste P12 exhibited even higher adhesive strength. Thus, the inclusion of an additive, here a copper additive (Paste P9), clearly improved performance. Paste P12, which performed better than Paste P3 and the Reference, contained Glass G9, which had a slightly lower amount of Bi₂O₃ and a slightly higher amount of Al₂O₃.

**Table 5. Adhesive Strength of Second Set of Exemplary Pastes P9 - P13**

| | **Reference** | **P3** | **P9** | **P10** | **P11** | **P12** | **P13** |
|---|---|---|---|---|---|---|---|
| Adhesion | 6.3 | 6.3 | 8.2 | 5.6 | 4.2 | 7.3 | 5.8 |

The results of Examples 1-2 illustrate that the inclusion of Bi₂O₃, Al₂O₃, SiO₂, B₂O₃ and at least one of Li₂O or Li₃PO₄ in the glass frit of an electroconductive paste resulted in adhesive performance well above industry standards and improved over the commercially available paste. More specifically, the inclusion of about 79-82 wt.% Bi₂O₃, 3-5 wt. % Al₂O₃, 3-5 wt. % SiO₂, 1-2 wt. % B₂O₃, and 10-15 wt. % Li₂O, proved to be optimal. The addition of a metallic copper additive further improved the resulting paste's adhesive performance.

These and other advantages of the invention will be apparent to those skilled in the art from the foregoing specification. Accordingly, it will be recognized by those skilled in the art that changes or modifications may be made to the above described embodiments without departing from the broad inventive concepts of the invention. Specific dimensions of any particular embodiment are described for illustration purposes only. It should therefore be understood that this invention is not limited to the particular embodiments described herein, but is intended to include all changes and modifications that are within the scope and spirit of the invention.

## Claims

1. An electroconductive paste composition for use in forming backside soldering pads on a solar cell comprising:
metallic particles;
glass frit including Bi₂O₃, Al₂O₃, SiO₂, B₂O₃ and at least one of Li₂O or Li₃PO₄; and
organic vehicle.

2. The electroconductive paste composition according to claim 1, wherein said glass frit comprises about 30-99.9%, preferably about 50-99.9%, more preferably about 70-90%, of said Bi₂O₃.

3. The electroconductive paste composition according to claim 1 or 2, wherein said glass frit comprises about 0.01-15%, more preferably about 1-10%, of said Al₂O₃.

4. The electroconductive paste composition according to any one of the preceding claims, wherein said glass frit comprises about 0.01-15%, more preferably about 1-10%, of said SiO₂.

5. The electroconductive paste composition according to any one of the preceding claims, wherein said glass frit comprises about 0.01-10%, more preferably about 0.01-5%, of said B₂O₃.

6. The electroconductive paste composition according to any one of the preceding claims, wherein said glass frit comprises about 0.01-20%, more preferably about 5-15%, of said at least one Li₂O or Li₃PO₄.

7. The electroconductive paste composition according to any one of the preceding claims, wherein said glass frit has a median particle diameter d50 of about 0.1 to about 10 µm, preferably about 0.1 to about 5 µm, more preferably about 0.1 to about 2 µm, most preferably about 0.1 to about 1 µm.

8. The electroconductive paste composition according to any one of the preceding claims, wherein said glass frit is about 0.01-10 wt% of paste, preferably about 0.01-7 wt%, more preferably about 0.01-6 wt%, and most preferably about 0.01-5 wt%.

9. The electroconductive paste composition according to any one of the preceding claims, wherein said metallic particles are about 30-75 wt%, preferably about 30-60 wt%, based upon 100% total weight of said electroconductive paste composition.

10. The electroconductive paste composition according to any one of the preceding claims, wherein said metallic particles are about 30-50 wt% of said electroconductive paste composition.

11. The electroconductive paste composition according to any one of the preceding claims, wherein said metallic particles comprise at least one of silver, aluminum, gold and nickel, or alloys or mixtures thereof.

12. The electroconductive paste composition according to any one of the preceding claims, wherein said metallic particles preferably comprise silver.

13. The electroconductive paste composition according to any one of the preceding claims, wherein said metallic particles preferably comprise silver and aluminum.

14. The electroconductive paste composition according to any one of the preceding claims, wherein said metallic particles have a median particle diameter d50 of about 0.1 to about 4 µm, preferably about 0.1 to about 3 µm, preferably about 0.1 to about 2 µm, and most preferably about 0.1 to about 1 µm.

15. The electroconductive paste composition according to any one of the preceding claims, wherein said metallic particles have a specific surface area of about 1 to about 3 m²/g, preferably about 2-3 m²/g.

16. The electroconductive paste composition according to any one of the preceding claims, wherein said organic vehicle is about 20-60 wt%, preferably about 30-50 wt%, most preferably about 40-50 wt% of electroconductive paste composition.

17. The electroconductive paste composition according to any one of the preceding claims, wherein said organic vehicle comprises a binder, a surfactant, an organic solvent and an additional compound selected from the group consisting of surfactants, thixotropic agents, viscosity regulators, stabilizing agents, inorganic additives, thickeners, emulsifiers, dispersants, pH regulators, and any combinations thereof.

18. The electroconductive paste composition according to claim 17, wherein said binder is at least one of poly-sugar, cellulose ester resin, phenolic resin, acrylic, polyvinyl butyral or polyester resin, polycarbonate, polyethylene or polyurethane resins, or rosin derivatives.

19. The electroconductive paste composition according to claim 17 or 18, wherein said surfactant is at least one of polyethylene oxide, polyethylene glycol, benzotriazole, poly(ethyleneglycol)acetic acid, lauric acid, oleic acid, capric acid, myristic acid, linoleic acid, stearic acid, palmitic acid, stearate salts, palmitate salts, and mixtures thereof.

20. The electroconductive paste composition according any one of claims 17-19, wherein said organic solvent is at least one of carbitol, terpineol, hexyl carbitol, texanol, butyl carbitol, butyl carbitol acetate, dimethyladipate or glycol ether.

21. The electroconductive paste composition according to any one of the preceding claims, further comprising about 0.01 - 1 wt% of at least one of aluminum, copper, an aluminum-silicon compound, an aluminum-phosphorus compound, and a copper compound.

22. The electroconductive paste composition according to any one of the preceding claims, further comprising an adhesion enhancer comprising a metal or a metal oxide, wherein said adhesion enhancer comprises at least one metal selected from the group consisting of tellurium, tungsten, molybdenum, vanadium, nickel, antimony, magnesium, zirconium, silver, cobalt, cerium, and zinc, or oxides thereof.

23. The electroconductive paste composition according to claim 22, wherein said adhesion enhancer is tellurium.

24. The electroconductive paste composition according to claim 22, wherein said adhesion enhancer is tellurium dioxide.

25. The electroconductive paste composition according to any one of claims 22-24, wherein said adhesion enhancer is dispersed within said glass frit.

26. The electroconductive paste composition according to any one of claims 22-25, wherein said adhesion enhancer is dispersed within said electroconductive paste composition independent from said glass frit.

27. The electroconductive paste composition according to any one of claims 22-26, wherein said adhesion enhancer is about 0.01-5 wt%, preferably about 0.05-2.5 wt%, most preferably about 0.05-1 wt%, of the electroconductive paste composition.

28. A solar cell comprising:
a silicon wafer having a front side and a backside; and
a soldering pad formed on the silicon wafer produced from an electroconductive paste according to any one of claims 1-27.

29. A solar cell according to claim 28, wherein said soldering pad is formed on said backside of said solar cell.

30. A solar cell according to claim 28 or 29, wherein said soldering pad may be removed from said silicon wafer with a pull force equal to or greater than 1 Newton.

31. A solar cell according to any one of claims 28-30, wherein said soldering pad may be removed from said silicon wafer with a pull force equal to or greater than 2 Newtons.

32. A solar cell according to any one of claims 28-31, wherein said soldering pad may be removed from said silicon wafer with a pull force equal to or greater than 3 Newtons.

33. A solar cell according to any one of claims 28-32, wherein said soldering pad may be removed from said silicon wafer with a pull force equal to or greater than 5 Newtons.

34. A solar cell according to any one of claims 28-33, wherein said soldering pad is formed from an electroconductive paste comprising about 30-75 wt% of metallic particles.

35. A solar cell according to any one of claims 28-34, wherein said soldering pad is formed from an electroconductive paste comprising about 30-60 wt% of metallic particles.

36. A solar cell according to any one of claims 28-35, wherein said soldering pad is formed from an electroconductive paste comprising about 30-50 wt% of metallic particles.

37. A solar cell according to any one of claims 28-36, wherein an electrode is formed on said front side of said silicon wafer.

38. A solar cell according to any one of claims 28-37, wherein said front side of said silicon wafer further comprises an antireflective layer.

39. A solar cell module comprising electrically interconnected solar cells according to any one of claims 28-38.

40. A method of producing a solar cell, comprising the steps of:
providing a silicon wafer having a front side and a backside;
applying an electroconductive paste composition according to any one of claims 1-27 onto said backside of said silicon wafer; and
firing said silicon wafer according to an appropriate profile.

41. The method of producing a solar cell according to claim 40, wherein said silicon wafer has an antireflective coating on said front side.

42. The method of producing a solar cell according to claim 40 or 41, further comprising the step of applying an aluminum-comprising paste to said backside of said silicon wafer overlapping the edges of said applied electroconductive paste composition according to claims 1-27.

43. The method of producing a solar cell according to any one of claims 40-42, further comprising the step of applying a silver-comprising paste to said front side of said silicon wafer.
